# EUROPEAN PATENT APPLICATION

(11) **EP 4 131 376 A1**
(43) Date of publication of application: **08.02.2023**
(21) Application number: 22188304.4
(22) Date of filing: 02.08.2022
(51) Int. Cl.: H01L 25/075, H01L 33/60, H01L 33/62

(54) **DISPLAY DEVICE**

(30) Priority: 02.08.2021 KR 20210101304
(71) Applicant: Samsung Display Co., Ltd., Yongin-si, Gyeonggi-do 17113 (KR)
(72) Inventor: KWAK, Jin Seon, Hwaseong-si, (KR); KIM, Kyung Bae, Suwon-si (KR); LEE, Yong Hee, Suwon-si (KR); LEE, Ji Hye, Hwaseong-si (KR); PYO, Ki Hyun, Seoul (KR)
(74) Representative: Taor, Simon Edward William

(57) **Abstract**

A display device includes sub-pixels including a light emitting part, and sub-areas on respective sides of the light emitting part in a first direction, a first electrode in the light emitting part and extending in the first direction, and a second electrode extending in the first direction and spaced apart from the first electrode in a second direction crossing the first direction, a first insulating layer on the first electrode and the second electrode, and a light emitting element on the first electrode and the second electrode in the light emitting part, wherein the second electrode includes an electrode stem part extending in the first direction, and electrode branch parts branched from the electrode stem part.

## Description

### CROSS-REFERENCE TO RELATED APPLICATION

This application claims priority to, and the benefit of, Korean Patent Application No. 10-2021-0101304 filed on August 02, 2021, in the Korean Intellectual Property Office.

### BACKGROUND

### 1. Field

The present disclosure relates to a display device.

### 2. Description of the Related Art

The importance of display devices has increased with the development of multimedia. Accordingly, various types of display devices, such as an organic light emitting display (OLED) and a liquid crystal display (LCD), have been used.

There is a self-light emitting display device including a light emitting element as a device displaying an image of the display device. The self-light emitting display device is a light emitting element, and includes an organic light emitting display device using an organic material as a light emitting material, an inorganic light emitting display device using an inorganic material as a light emitting material, or the like.

### SUMMARY

Aspects of the present disclosure provide a display device in which the number of lines is decreased by applying the same second source voltage to each of adjacent sub-pixels through the same second electrode.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to embodiments, a display device includes sub-pixels including a light emitting part, and sub-areas on respective sides of the light emitting part in a first direction, a first electrode in the light emitting part and extending in the first direction, and a second electrode extending in the first direction and spaced apart from the first electrode in a second direction crossing the first direction, a first insulating layer on the first electrode and the second electrode, and a light emitting element on the first electrode and the second electrode in the light emitting part, wherein the second electrode includes an electrode stem part extending in the first direction, and electrode branch parts branched from the electrode stem part.

The display device may further include a bank layer separating adjacent ones of the sub-pixels, wherein the sub-pixels are arranged along the first direction and the second direction.

The bank layer may be in a lattice shape along the first direction and the second direction.

The light emitting part and the sub-area may be surrounded by portions of the bank layer extending in the first direction and the second direction.

The first electrode may be over the sub-area, and may define an opening hole in the sub-area.

The display device may further include a second insulating layer on the first insulating layer, and separation parts respectively in sub-areas, the first insulating layer and the second insulating layer not being therein, wherein the first electrode contacts adjacent ones of the separation parts of adjacent ones of the sub-areas.

The display device may further include a first connection electrode on the first electrode in the light emitting part, and in contact with the light emitting element, and a second connection electrode on the second electrode in the light emitting part, and in contact with the light emitting element, wherein the first insulating layer further includes a first contact part overlapping the first electrode in the light emitting part, and a second contact part overlapping the second electrode in the light emitting part, wherein the first connection electrode is in contact with the first electrode through the first contact part, and wherein the second connection electrode is in contact with the second electrode through the second contact part.

The display device may further include a third insulating layer on the second insulating layer, and covering the separation parts in the sub-area.

The electrode stem part may overlap a portion of the bank layer extending in the first direction, and is on one side of the sub-area in the second direction.

The electrode branch parts may be branched from a first portion of the electrode stem part at a portion of the bank layer extending in the first direction and at a portion of the bank layer extending in the second direction, and are bent to respective sides in the second direction.

The electrode branch parts may cross the light emitting part in the first direction, are bent again, and may be integrated with a second portion of the electrode stem part to be connected to each other.

The electrode branch parts of the second electrode may include a first electrode branch part on a left side of the first electrode, and a second electrode branch part on a right side of the first electrode.

The electrode branch parts in one second electrode may be respectively in the light emitting parts of adjacent ones of the sub-pixels neighboring in the second direction, wherein the electrode branch parts of different ones of the second electrodes are in one sub-pixel.

The display device may further include a first bank pattern at a central portion of the light emitting part, and second bank patterns spaced apart from the first bank pattern with the first bank pattern interposed therebetween, wherein the first bank pattern and the second bank patterns are alternately arranged along the second direction, and wherein the light emitting element is between the first bank pattern and one of the second bank patterns.

The first electrode may be at a center of the sub-pixel, wherein a portion of the first electrode in the light emitting part is on the first bank pattern, and wherein the first electrode extends in the first direction from the sub-area to a sub-area of an adjacent sub-pixel.

A width of the first electrode in the second direction may be different depending on a position thereof in the first direction, wherein the portion of the first electrode in the light emitting part on the first bank pattern has a width that is greater than a width of the first bank pattern.

The first electrode may cover both side surfaces of the first bank pattern.

According to embodiments, a display device includes sub-pixels including a light emitting part, and sub-areas on respective sides of the light emitting part in a first direction, a first electrode in the light emitting part and extending in the first direction, and a second electrode extending in the first direction and spaced apart from the first electrode in a second direction crossing the first direction, a first insulating layer on the first electrode and the second electrode, a light emitting element on the first electrode and the second electrode in the light emitting part, a first bank pattern at a central portion of the light emitting part below the first electrode and the second electrode, second bank patterns spaced apart from the first bank pattern with the first bank pattern interposed therebetween, and a bank layer on the first insulating layer, and separating adjacent ones of the sub-pixels, wherein the light emitting element is between the first bank pattern and one of the second bank patterns, and wherein the first insulating layer defines an opening pattern overlapping the bank layer.

The sub-pixels may be arranged along the first direction and the second direction, wherein the bank layer is in a lattice shape along the first direction and the second direction, and wherein the opening pattern is arranged along the bank layer, and extends in the first direction in plan view.

The second electrode may include an electrode stem part extending in the first direction, and electrode branch parts branched from the electrode stem part, wherein the opening pattern is between the electrode branch parts in plan view.

According to an aspect, there is provided a display device as set out in claim 1. Additional features are set out in claims 2 to 12. According to an aspect, there is provided a display device as set out in claim 13. Additional features are set out in claims 14 and 15.

Detailed contents of other embodiments are described in a detailed description and are illustrated in the drawings.

With the display device according to embodiments, the number of lines may be decreased by applying the same second source voltage to each of adjacent sub-pixels through the same second electrode.

The aspects of the present disclosure are not limited to the aforementioned aspects, and various other aspects are included in the present specification.

### BRIEF DESCRIPTION OF THE DRAWINGS

The above and other aspects of the present disclosure will become more apparent by describing in detail embodiments thereof with reference to the attached drawings, in which:
FIG. 1 is a schematic plan view of a display device according to some embodiments;
FIG. 2 is a layout diagram illustrating sub-pixels according to some embodiments;
FIG. 3 is a cross-sectional view illustrating an example of a display panel taken along the line Q1-Q1' of FIG. 2;
FIG. 4 is a plan view illustrating one pixel of the display device according to some embodiments;
FIG. 5 is a view illustrating a first sub-pixel of FIG. 4;
FIG. 6 is a cross-sectional view taken along the lines N1-N1', N2-N2', and N3-N3' of FIG. 5;
FIG. 7 is a cross-sectional view taken along the lines N4-N4', N5-N5', and N6-N6' of FIG. 5;
FIG. 8 is an enlarged view of portion B of FIG. 5;
FIG. 9 is a cross-sectional view taken along the line N7-N7' of FIG. 8;
FIGS. 10 and 11 are views illustrating shapes of electrodes in a sub-area in a process of manufacturing the display device;
FIG. 12 is a view illustrating a light emitting element according to some embodiments;
FIG. 13 is a schematic view illustrating outgassing through an opening hole of a first insulating layer according to some embodiments;
FIG. 14 is a plan view illustrating one pixel of a display device according to other embodiments; and
FIG. 15 is a plan view illustrating one pixel of a display device according to still other embodiments.

### DETAILED DESCRIPTION

Aspects of some embodiments of the present disclosure and methods of accomplishing the same may be understood more readily by reference to the detailed description of embodiments and the accompanying drawings. Hereinafter, embodiments will be described in more detail with reference to the accompanying drawings. The described embodiments, however, may have various modifications and may be embodied in various different forms, and should not be construed as being limited to only the illustrated embodiments herein. Rather, these embodiments are provided as examples so that this disclosure will be thorough and complete, and will fully convey the aspects of the present disclosure to those skilled in the art, and it should be understood that the present disclosure covers all the modifications, equivalents, and replacements within the idea and technical scope of the present disclosure. Accordingly, processes, elements, and techniques that are not necessary to those having ordinary skill in the art for a complete understanding of the aspects of the present disclosure may not be described.

Unless otherwise noted, like reference numerals, characters, or combinations thereof denote like elements throughout the attached drawings and the written description, and thus, descriptions thereof will not be repeated. Further, parts that are not related to, or that are irrelevant to, the description of the embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the particular illustrated shapes of regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form in order to avoid unnecessarily obscuring various embodiments.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, YZ, and ZZ, or any variation thereof. Similarly, the expression such as "at least one of A and B" may include A, B, or A and B. As used herein, "or" generally means "and/or," and the term "and/or" includes any and all combinations of one or more of the associated listed items. For example, the expression such as "A and/or B" may include A, B, or A and B.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the relevant requirements.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

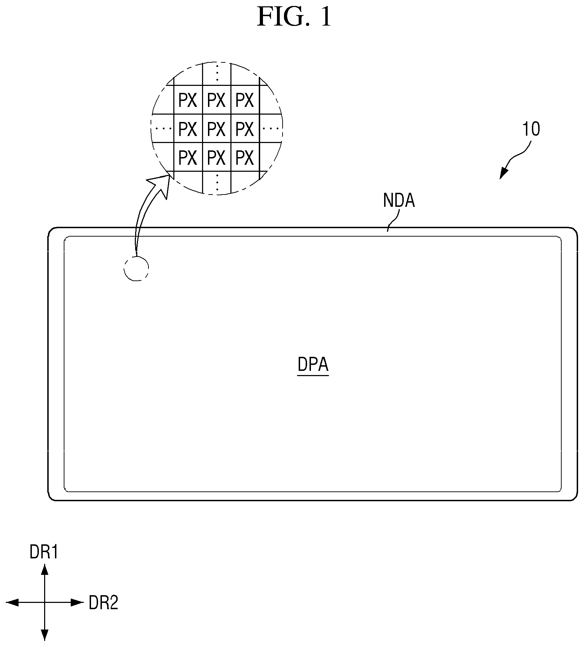

FIG. 1 is a schematic plan view of a display device according to some embodiments.

Referring to FIG. 1, a display device 10 displays a moving image or a still image. The display device 10 may refer to all electronic devices that provide display screens. For example, televisions, laptop computers, monitors, billboards, the Internet of Things (loT), mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras, camcorders, and the like, which provide display screens, may be included in the display device 10.

The display device 10 includes a display panel providing a display screen. Examples of the display panel may include an inorganic light emitting diode display panel, an organic light emitting display panel, a quantum dot light emitting display panel, a plasma display panel, a field emission display panel, and the like.
Hereinafter, a case where an inorganic light emitting diode display panel is applied as an example of the display panel will be described by way of example, but embodiments of the present disclosure are not limited thereto, and the same technical spirit may be applied to other display panels if applicable.

A shape of the display device 10 may be variously changed. For example, the display device 10 may have a shape such as a rectangular shape with a width that is greater than a length, a rectangular shape with a length that is greater than a width, a square shape, a rectangular shape with rounded corners (vertices), other polygonal shapes, or a circular shape. A shape of a display area DPA of the display device 10 may also be similar to an overall shape of the display device 10. In FIG. 1, the display device 10 having a rectangular shape with a greater length in a second direction DR2 than a width in a first direction DR1 is illustrated.

The display device 10 may include a display area DPA and a non-display area NDA. The display area DPA is an area in which a screen may be displayed, and the non-display area NDA is an area in which a screen is not displayed. The display area DPA may also be referred to as an active area, and the non-display area NDA may also be referred to as a non-active area. The display area DPA may occupy substantially the center of the display device 10.

The display area DPA may include a plurality of pixels PX. The plurality of pixels PX may be arranged in a matrix direction. A shape of each pixel PX may be a rectangular shape or a square shape in plan view, but embodiments are not limited thereto, and may also be a rhombic shape of which each side is inclined with respect to one direction. The respective pixels PX may be alternately arranged in a stripe type or a PENTILE^{™} type (e.g., a PENTILE^{™} matrix structure, a PENTILE^{™} structure, or an RGBG structure). PENTILE^{™} is a registered trademark of Samsung Display Co., Ltd., Republic of Korea. In addition, each of the pixels PX may include one or more light emitting elements emitting light of a corresponding wavelength band to display a corresponding color.

The non-display area NDA may be located around the display area DPA. The non-display area NDA may entirely or partially surround the display area DPA. The display area DPA may have a rectangular shape, and the non-display area NDA may be located adjacent to four sides of the display area DPA. The non-display area NDA may constitute a bezel of the display device 10. Lines or circuit drivers included in the display device 10 may be located, or external devices may be mounted, in the non-display area NDA.

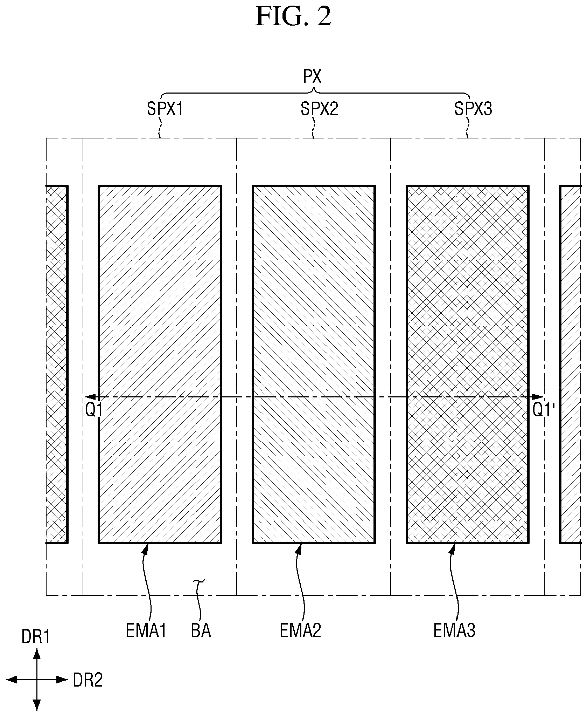

FIG. 2 is a layout diagram illustrating sub-pixels according to some embodiments.

Referring to FIG. 2, the plurality of pixels PX may be arranged in a first direction DR1 and a second direction DR2 in the display area DA. Each of the plurality of pixels PX may include a plurality of sub-pixels SPX1, SPX2, and SPX3. For example, each of the plurality of pixels PX may include three sub-pixels, that is, a first sub-pixel SPX1, a second sub-pixel SPX2, and a third sub-pixel SPX3, as illustrated in FIG. 2, but the number of sub-pixels included in each of the plurality of pixels PX is not limited thereto in embodiments. For example, each of the plurality of pixels PX may include four or more sub-pixels.

The plurality of sub-pixels SPX1, SPX2, and SPX3 may be arranged in the second direction DR2, but an arrangement direction of the plurality of sub-pixels SPX1, SPX2, and SPX3 is not limited thereto in embodiments. For example, the plurality of sub-pixels SPX1, SPX2, and SPX3 may be arranged in the first direction DR1.

Each of the plurality of sub-pixels SPX1, SPX2, and SPX3 may include a light emitting part and a light blocking part. For example, the first sub-pixel SPX1 may include a first light emitting part EMA1 and a light blocking part BA (e.g., a portion of the light blocking part BA), the second sub-pixel SPX2 may include a second light emitting part EMA2 and a light blocking part BA (e.g., an additional portion of the light blocking part BA), and the third sub-pixel SPX3 may include a third light emitting part EMA3 and a light blocking part BA (e.g., another portion of the light blocking part BA).

The first light emitting part EMA1, the second light emitting part EMA2, and the third light emitting part EMA3 may emit light of the same color. In this case, the first sub-pixel SPX1 may convert light of a third color output from the first light emitting part EMA1 into light of a first color, and may output the light of the first color. The second sub-pixel SPX2 may convert light of a third color output from the second light emitting part EMA2 into light of a second color, and may output the light of the second color. The third sub-pixel SPX3 may output light of a third color that is output from the third light emitting part EMA3 as it is.

Alternatively, the first light emitting part EMA1, the second light emitting part EMA2, and the third light emitting part EMA3 may emit light of different respective colors. In this case, the first sub-pixel SPX1 may output light of a first color that is output from the first light emitting part EMA1, the second sub-pixel SPX2 may output light of a second color that is output from the second light emitting part EMA2, and the third sub-pixel SPX3 may output light of a third color that is output from the third light emitting part EMA3.

It has been illustrated in FIG. 2 that the first light emitting part EMA1, the second light emitting part EMA2, and the third light emitting part EMA3 have the same area, but embodiments of the present disclosure are not limited thereto. The first light emitting part EMA1, the second light emitting part EMA2, and the third light emitting part EMA3 may have different areas corresponding to respective colors of the light or wavelength bands of the light.

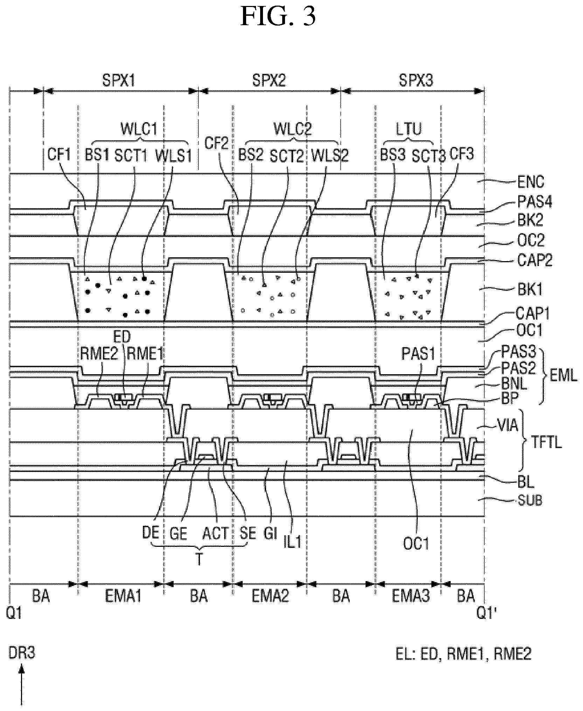

FIG. 3 is a cross-sectional view illustrating an example of a display panel taken along the line Q1-Q1' of FIG. 2.

Referring to FIGS. 2 and 3, the display device may include a substrate SUB, a buffer layer BL, a thin film transistor layer TFTL, and a light emitting element layer EML.

The substrate SUB may be a base substrate or a base member, and may be made of an insulating material such as a polymer resin. As an example, the substrate SUB may be a rigid substrate. When the substrate SUB is the rigid substrate, the substrate SUB may include a glass material or a metal material, but embodiments are not limited thereto. As another example, the substrate SUB may be a flexible substrate that may be bent, folded, or rolled. When the substrate SUB is the flexible substrate, the substrate SUB may include polyimide PI, but embodiments are not limited thereto.

The buffer layer BL may be located on the substrate SUB. The buffer layer BL may be formed as an inorganic film capable of reducing or preventing permeation of air or moisture. For example, the buffer layer BL may include a plurality of inorganic films that are alternately stacked.

The thin film transistor layer TFTL may include a thin film transistor T, a gate insulating film GI, an interlayer insulating film IL1, and a via layer VIA.

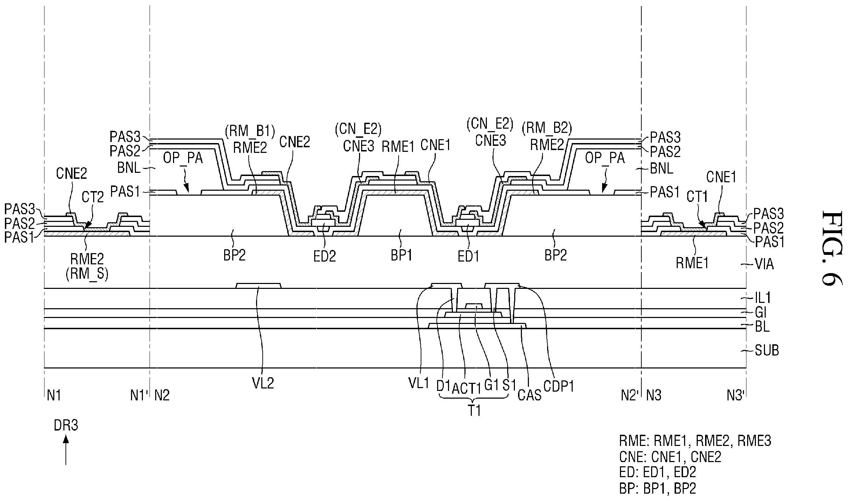

The thin film transistor T may be located on the buffer layer BL, and may constitute a pixel circuit of each of the plurality of pixels. For example, the thin film transistor T may be a driving transistor (e.g., a first transistor T1 of FIG. 6) or a switching transistor of the pixel circuit. The thin film transistor T may include a semiconductor layer ACT, a gate electrode GE, a source electrode SE, and a drain electrode DE.

The semiconductor layer ACT may be provided on the buffer layer BL. The semiconductor layer ACT may overlap the gate electrode GE, the source electrode SE, and the drain electrode DE. The semiconductor layer ACT may be in direct contact with the source electrode SE and the drain electrode DE, and may face the gate electrode GE with the gate insulating film GI interposed therebetween.

The gate electrode GE may be located on the gate insulating film GI. The gate electrode GE may overlap the semiconductor layer ACT with the gate insulating film GI interposed therebetween.

The source electrode SE and the drain electrode DE may be spaced apart from each other on the interlayer insulating film IL1. The source electrode SE may be in contact with one end of the semiconductor layer ACT through a contact hole provided in the gate insulating film GI and the interlayer insulating film IL1. The drain electrode DE may be in contact with the other end of the semiconductor layer ACT through a contact hole provided in the gate insulating film GI and the interlayer insulating film IL1. The drain electrode DE may be connected to a first electrode RME1 of a light emitting member EL through the contact hole provided in the gate insulating film GI and the interlayer insulating film IL1.

The gate insulating film GI may be provided on the semiconductor layer ACT. For example, the gate insulating film GI may be located on the semiconductor layer ACT and the buffer layer BL, and may insulate the semiconductor layer ACT and the gate electrode GE from each other. The gate insulating film GI may include a contact hole through which the source electrode SE penetrates therethrough, and a contact hole through which the drain electrode DE penetrates therethrough.

The interlayer insulating film IL1 may be located on the gate electrode GE. For example, the interlayer insulating film IL1 may include a contact hole through which the source electrode SE penetrates therethrough, and a contact hole through which the drain electrode DE penetrates therethrough. Here, the contact holes of the interlayer insulating film IL1 may be connected to, or in continuity with, the contact holes of the gate insulating film GI.

The via layer VIA may be provided on the interlayer insulating film IL1 to planarize an upper end of the thin film transistor T. For example, the via layer VIA may include a contact hole through which the first electrode RME1 of the light emitting member EL penetrates therethrough. Here, the contact hole of the via layer VIA may be connected to, or in continuity with, the contact hole of the first gate insulating film GI.

The light emitting element layer EML may include the light emitting member EL, bank patterns BP (BP1 and BP2), a bank layer BNL, a first passivation layer PAS1, a second passivation layer PAS2, and a third passivation layer PAS3.

The light emitting member EL may be provided on the thin film transistor T. The light emitting member EL may include the first electrode RME1, a second electrode RME2, and a light emitting element ED.

The first electrode RME1 may be provided on the via layer VIA. For example, the first electrode RME1 may be located on the bank pattern BP (e.g., a first bank pattern BP1) located on the via layer VIA to cover the bank pattern BP. In addition, the first electrode RME1 may be connected to the drain electrode DE of the thin film transistor T. The first electrode RME1 may be an anode electrode of the light emitting element ED, but embodiments are not limited thereto.

The second electrode RME2 may be provided on the via layer VIA. For example, the second electrode RME2 may be located on the bank pattern BP (e.g., a second bank pattern BP2) located on the via layer VIA to cover the bank pattern BP. For example, the second electrode RME2 may receive a common voltage supplied to all pixels. The second electrode RME2 may be a cathode electrode of the light emitting element ED, but embodiments are not limited thereto.

The first insulating layer PAS1 may cover a portion of the first electrode RME1 and a portion of the second electrode RME2 adjacent to each other, and may insulate the first electrode RME1 and the second electrode RME2 from each other.

The light emitting element ED may be located between the first electrode RME1 and the second electrode RME2 above the via layer VIA. The light emitting element ED may be located on the first insulating layer PAS1. One end of the light emitting element ED may be connected to the first electrode RME1, and the other end of the light emitting element ED may be connected to the second electrode RME2. For example, a plurality of light emitting elements ED may include active layers having the same material to emit light of the same wavelength band, or to emit light of the same color. Light emitted from each of the first to third light emitting parts EMA1, EMA2, and EMA3 may have the same color. For example, the plurality of light emitting elements ED may emit light of a third color, or blue light, having a peak wavelength in the range of about 440 nm to about 480 nm. Therefore, the light emitting element layer EML may emit the light of the third color or the blue light.

The bank layer BNL may be located on the via layer VIA. The bank layer BNL may separate and insulate the first electrodes RME1 or the second electrodes RME2 of each of a plurality of light emitting members EL from each other.

The second passivation layer PAS2 and the third passivation layer PAS3 may be located on the plurality of light emitting members EL and the bank layer BNL. The second passivation layer PAS2 may cover the plurality of light emitting members EL, and may protect the plurality of light emitting members EL. The second passivation layer PAS2 and the third passivation layer PAS3 may reduce or prevent permeation of impurities, such as moisture or air from the outside, to reduce or prevent the likelihood of damage to the plurality of light emitting members EL.

The display device 10 may further include a first planarization layer OC1, a first capping layer CAP1, a first light blocking member BK1, a first wavelength conversion part WLC1, a second wavelength conversion part WLC2, a light transmission part LTU, a second capping layer CAP2, a second planarization layer OC2, a second light blocking member BK2, first to third color filters CF1, CF2, and CF3, a fourth passivation layer PAS4, and an encapsulation layer ENC.

The first planarization layer OC1 may be provided on the light emitting element layer EML to planarize an upper end of the light emitting element layer EML. The first planarization layer OC1 may include an organic material. For example, the first planarization layer OC1 may include at least one of an acrylic resin, an epoxy resin, a phenolic resin, a polyamide resin, and a polyimide resin.

The first capping layer CAP1 may be located on the first planarization layer OC1. The first capping layer CAP1 may seal lower surfaces of the first and second wavelength conversion parts WLC1 and WLC2 and the light transmission part LTU. The first capping layer CAP1 may include an inorganic material. For example, the first capping layer CAP1 may include at least one of silicon nitride, aluminum nitride, zirconium nitride, titanium nitride, hafnium nitride, tantalum nitride, silicon oxide, aluminum oxide, titanium oxide, tin oxide, cerium oxide, and silicon oxynitride.

The first light blocking member BK1 may be located in the light blocking parts BA and on the first capping layer CAP1. The first light blocking member BK1 may overlap the bank layer BNL in a thickness direction. The first light blocking member BK1 may block transmission of light. The first light blocking member BK1 may reduce or prevent colors being mixed with each other due to permeation of the light between the first to third light emitting parts EMA1, EMA2, and EMA3 to improve a color reproduction rate. The first light blocking member BK1 may be located in a lattice shape surrounding the first to third light emitting parts EMA1, EMA2, and EMA3 in plan view.

The first light blocking member BK1 may include an organic light blocking material and a liquid repellent component. Here, the liquid repellent component may be made of a fluorine-containing monomer or a fluorine-containing polymer, and, for example, may include a fluorine-containing aliphatic polycarbonate. For example, the first light blocking member BK1 may be made of a black organic material including a liquid repellent component. The first light blocking member BK1 may be formed through coating and exposing processes or the like of an organic light blocking material including a liquid repellent component.

The first light blocking member BK1 includes the liquid repellent component, and may thus separate the first and second wavelength conversion parts WLC1 and WLC2 and the light transmission part LTU into corresponding light emitting parts EMA. For example, when the first and second wavelength conversion parts WLC1 and WLC2 and the light transmission part LTU are formed in an inkjet manner, an ink composition may flow onto an upper surface of the first light blocking member BK1. In this case, the first light blocking member BK1 may include the liquid repellent component to guide the ink compositions to flow into each of transmission areas. Accordingly, the first light blocking member BK1 may reduce or prevent the ink compositions being mixed with each other.

The first wavelength conversion part WLC1 may be located in the first light emitting part EMA1 on the first capping layer CAP1. The first wavelength conversion part WLC1 may be surrounded by the first light blocking member BK1. The first wavelength conversion part WLC1 may include a first base resin BS1, first scatterers SCT1, and first wavelength shifters WLS1.

The first base resin BS1 may include a material having a relatively high light transmittance. The first base resin BS1 may be made of a transparent organic material. For example, the first base resin BS1 may include at least one of organic materials such as an epoxy-based resin, an acrylic resin, a cardo-based resin, and an imide-based resin.

The first scatterer SCT1 may have a refractive index different from that of the first base resin BS1, and may form an optical interface with the first base resin BS1. For example, the first scatterer SCT1 may include a light scattering material or a light scattering particle for scattering at least a portion of transmitted light. For example, the first scatterer SCT1 may include a metal oxide such as titanium oxide (TiO₂), zirconium oxide (ZrO₂), aluminum oxide (Al₂O₃), indium oxide (In₂O₃), zinc oxide (ZnO), or tin oxide (SnO₂) or include an organic particle such as an acrylic resin or a urethane-based resin. The first scatterer SCT1 may scatter light in a random direction regardless of an incident direction of incident light without substantially converting a peak wavelength of the incident light.

The first wavelength shifter WLS1 may convert or shift the peak wavelength of the incident light to a first peak wavelength. For example, the first wavelength shifter WLS1 may convert the blue light provided from the display device 10 into red light having a single peak wavelength in the range of about 610 nm to about 650 nm, and may emit the red light. The first wavelength shifter WLS1 may be a quantum dot, a quantum rod, or a phosphor. The quantum dot may be a particulate matter for emitting a corresponding color while electrons are transitioning from a conduction band to a valence band.

For example, the quantum dot may be a semiconductor nanocrystal material. The quantum dot may have a corresponding band gap according to its composition and size to absorb light, and then may emit light having a unique wavelength. Examples of semiconductor nanocrystals of the quantum dot may include group IV nanocrystals, group II-VI compound nanocrystals, group III-V compound nanocrystals, group IV-VI compound nanocrystals, or combinations thereof.

A group II-VI compound may be selected from the group consisting of a binary compound selected from the group consisting of CdSe, CdTe, ZnS, ZnSe, ZnTe, ZnO, HgS, HgSe, HgTe, MgSe, MgS, and mixtures thereof; a ternary compound selected from the group consisting of InZnP, AglnS, CulnS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and mixtures thereof; and/or a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and mixtures thereof.

A group III-V compound may be selected from the group consisting of a binary compound selected from the group consisting of GaN, GaP, GaAs, GaSb, AIN, AlP, AlAs, AlSb, InN, InP, InAs, InSb, and mixtures thereof; a ternary compound selected from the group consisting of GaNP, GaNAs, GaNSb, GaPAs, GaPSb, AINP, AINAs, AINSb, AlPAs, AlPSb, InGaP, InNP, InAlP, InNAs, InNSb, InPAs, InPSb, GaAINP, and mixtures thereof; and/or a quaternary compound selected from the group consisting of GaAINAs, GaAINSb, GaAIPAs, GaAIPSb, GaInNP, GaInNAs, GaInNSb, GaInPAs, GaInPSb, InAINP, InAINAs, InAINSb, InAIPAs, InAIPSb, and mixtures thereof.

A group IV-VI compound may be selected from the group consisting of a binary compound selected from the group consisting of SnS, SnSe, SnTe, PbS, PbSe, PbTe, and mixtures thereof; a ternary compound selected from the group consisting of SnSeS, SnSeTe, SnSTe, PbSeS, PbSeTe, PbSTe, SnPbS, SnPbSe, SnPbTe, and mixtures thereof; and/or a quaternary compound selected from the group consisting of SnPbSSe, SnPbSeTe, SnPbSTe, and mixtures thereof. A group IV element may be selected from the group consisting of Si, Ge, and mixtures thereof. A group IV compound may be a binary compound selected from the group consisting of SiC, SiGe, and mixtures thereof.

For example, the binary compound, the ternary compound, or the quaternary compound may be present in a particle at a uniform concentration or may be present in the same particle in a state in which concentration distributions are partially different from each other.

For example, the quantum dot may have a core-shell structure including a core including the above-described nanocrystals and a shell surrounding the core. The shell of the quantum dot may serve as a protective layer for maintaining semiconductor characteristics by reducing or preventing chemical modification of the core and/or serve as a charging layer for imparting electrophoretic characteristics to the quantum dot. The shell may be a single layer or a multilayer. An interface between the core and the shell may have a concentration gradient in which a concentration of element present in the shell decreases toward the center. The shell of the quantum dot may be made of a metal or non-metal oxide, a semiconductor compound, a combination thereof, or the like.

Examples of the metal or non-metal oxide may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO, or a ternary compound such as MgAl₂O₄, CoFe₂O₄, NiFe₂O₄, or CoMn₂O₄, but embodiments of the present disclosure are not limited thereto.

In addition, examples of the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or the like, but embodiments of the present disclosure are not limited thereto.

The light emitted by the first wavelength shifter WLS1 may have a full width of half maximum (FWHM) of an emission wavelength spectrum of about 45 nm or less, about 40 nm or less, or about 30 nm or less, and may further improve color purity and color reproducibility of colors displayed by the display device 10. The light emitted by the first wavelength shifter WLS1 may be emitted toward several directions regardless of the incident direction of the incident light. Accordingly, side visibility of a red color displayed on the first light emitting part EMA1 may be improved.

A portion of the blue light provided from the light emitting element layer EML may be transmitted through the first wavelength conversion part WLC1 without being converted into red light by the first wavelength shifter WLS1. Light incident on the first color filter CF1 without being converted by the first wavelength conversion part WLC1 in the blue light provided from the light emitting element layer EML may be blocked by the first color filter CF1. In addition, the red light converted by the first wavelength conversion part WLC1 in the blue light provided from the display device 10 may be transmitted through the first color filter CF1 and then emitted to the outside. Accordingly, the first light emitting part EMA1 may emit the red light.

The second wavelength conversion part WLC2 may be located in the second light emitting part EMA2 on the first capping layer CAP1. The second wavelength conversion part WLC2 may be surrounded by the first light blocking member BK1. The second wavelength conversion part WLC2 may include a second base resin BS2, second scatterers SCT2, and second wavelength shifters WLS2.

The second base resin BS2 may include a material having a relatively high light transmittance. The second base resin BS2 may be made of a transparent organic material. For example, the second base resin BS2 may be made of the same material as the first base resin BS1, or may be made of the material exemplified in the first base resin BS1.

The second scatterer SCT2 may have a refractive index different from that of the second base resin BS2, and may form an optical interface with the second base resin BS2. For example, the second scatterer SCT2 may include a light scattering material or a light scattering particle for scattering at least a portion of transmitted light. For example, the second scatterer SCT2 may be made of the same material as the first scatterer SCT1, or may be made of the material exemplified in the first scatterer SCT1. The second scatterer SCT2 may scatter light in a random direction regardless of an incident direction of incident light without substantially converting a peak wavelength of the incident light.

The second wavelength shifter WLS2 may convert or shift the peak wavelength of the incident light to a second peak wavelength that is different from the first peak wavelength corresponding to the first wavelength shifter WLS1. For example, the second wavelength shifter WLS2 may convert the blue light provided from the display device 10 into green light having a single peak wavelength in the range of about 510 nm to about 550 nm, and may emit the green light. The second wavelength shifter WLS2 may be a quantum dot, a quantum rod, or a phosphor. The second wavelength shifter WLS2 may include the same material as the material exemplified in the first wavelength shifter WLS1. The second wavelength shifter WLS2 may be made of the quantum dot, the quantum rod, or the phosphor so that a wavelength conversion range of the second wavelength shifter WLS2 is different from a wavelength conversion range of the first wavelength shifter WLS1.

The light transmission part LTU may be located in the third light emitting part EMA3 on the first capping layer CAP1. The light transmission part LTU may be surrounded by the first light blocking member BK1. The light transmission part LTU may transmit incident light therethrough while maintaining a peak wavelength of the incident light. The light transmission part LTU may include a third base resin BS3 and third scatterers SCT3.

The third base resin BS3 may include a material having a relatively high light transmittance. The third base resin BS3 may be made of a transparent organic material. For example, the third base resin BS3 may be made of the same material as the first or second base resin BS1 or BS2, or may be made of the material exemplified in the first or second base resin BS1 or BS2.

The third scatterer SCT3 may have a refractive index that is different from that of the third base resin BS3, and may form an optical interface with the third base resin BS3. For example, the third scatterer SCT3 may include a light scattering material or a light scattering particle for scattering at least a portion of transmitted light. For example, the third scatterer SCT3 may be made of the same material as the first or second scatterer SCT1 or SCT2, or may be made of the material exemplified in the first or second scatterer SCT1 or SCT2. The third scatterer SCT3 may scatter light in a random direction regardless of an incident direction of incident light without substantially converting a peak wavelength of the incident light.

Because the first and second wavelength conversion parts WLC1 and WLC2 and the light transmission part LTU are located on the light emitting element layer EML (e.g., above the first planarization layer OC1 and the first capping layer CAP1), the display device 10 may not require a separate substrate for the first and second wavelength conversion parts WLC1 and WLC2 and the light transmission part LTU. Accordingly, the first and second wavelength conversion parts WLC1 and WLC2 and the light transmission part LTU may be suitably aligned in the first to third light emitting parts EMA1, EMA2 and EMA3, respectively, and a thickness of the display device 10 may be relatively decreased.

The second capping layer CAP2 may cover the first and second wavelength conversion parts WLC1 and WLC2, the light transmission part LTU, and the first light blocking member BK1. For example, the second capping layer CAP2 may seal the first and second wavelength conversion parts WLC1 and WLC2 and the light transmission part LTU to reduce or prevent the likelihood of damage to, or contamination of, the first and second wavelength conversion parts WLC1 and WLC2 and the light transmission part LTU. The second capping layer CAP2 may be made of the same material as the first capping layer CAP1, or may be made of the material exemplified in the first capping layer CAP1.

The second planarization layer OC2 may be located on the second capping layer CAP2 to planarize upper ends of the first and second wavelength conversion parts WLC1 and WLC2 and the light transmission part LTU. The second planarization layer OC2 may include an organic material. For example, the second planarization layer OC2 may include at least one of an acrylic resin, an epoxy resin, a phenolic resin, a polyamide resin, and a polyimide resin.

The second light blocking member BK2 may be located in the light blocking parts BA on the second planarization layer OC2. The second light blocking member BK2 may overlap the first light blocking member BK1 or the bank layer BNL in the thickness direction. The second light blocking member BK2 may block transmission of light. The second light blocking member BK2 may reduce or prevent colors being mixed with each other due to permeation of the light between the first to third light emitting parts EMA1, EMA2, and EMA3 to improve a color reproduction rate. The second light blocking member BK2 may be located in a lattice shape surrounding the first to third light emitting parts EMA1, EMA2, and EMA3 in plan view.

The first color filter CF1 may be located in the first light emitting part EMA1 on the second planarization layer OC2. The first color filter CF1 may be surrounded by the second light blocking member BK2. The first color filter CF1 may overlap the first wavelength conversion part WLC1 in the thickness direction. The first color filter CF1 may selectively transmit light of a first color (e.g., red light), and may block or may absorb light of a second color (e.g., green light) and light of a third color (e.g., blue light). For example, the first color filter CF1 may be a red color filter, and may include a red colorant. The red colorant may be made of a red dye or a red pigment.

The second color filter CF2 may be located in the second light emitting part EMA2 on the second planarization layer OC2. The second color filter CF2 may be surrounded by the second light blocking member BK2. The second color filter CF2 may overlap the second wavelength conversion part WLC2 in the thickness direction. The second color filter CF2 may selectively transmit the light of the second color (e.g., the green light), and may block or may absorb the light of the first color (e.g., the red light) and the light of the third color (e.g., the blue light). For example, the second color filter CF2 may be a green color filter, and may include a green colorant. The green colorant may be made of a green dye or a green pigment.

The third color filter CF3 may be located in the third light emitting part EMA3 on the second planarization layer OC2. The third color filter CF3 may be surrounded by the second light blocking member BK2. The third color filter CF3 may overlap the light transmission part LTU in the thickness direction. The third color filter CF3 may selectively transmit the light of the third color (e.g., the blue light), and may block or may absorb the light of the first color (e.g., the red light) and the light of the second color (e.g., the green light). For example, the third color filter CF3 may be a blue color filter, and may include a blue colorant. The blue colorant may be made of a blue dye or a blue pigment.

The first to third color filters CF1, CF2, and CF3 may absorb a portion of light introduced from the outside of the display device 10 to reduce reflected light due to external light. Therefore, the first to third color filters CF1, CF2, and CF3 may reduce or prevent distortion of colors due to external light reflection.

Because the first to third color filters CF1, CF2, and CF3 are located on the first and second wavelength conversion parts WLC1 and WLC2 and the light transmission part LTU, respectively, through the second planarization layer OC2, the display device 10 may not require a separate substrate for the first to third color filters CF1, CF2, and CF3. Accordingly, a thickness of the display device 10 may be relatively decreased.

The fourth passivation layer PAS4 may cover the first to third color filters CF1, CF2, and CF3. The fourth passivation layer PAS4 may protect the first to third color filters CF1, CF2, and CF3.

The encapsulation layer ENC may be located on the fourth passivation layer PAS4. For example, the encapsulation layer ENC may include at least one inorganic film to reduce or prevent permeation of oxygen or moisture. In addition, the encapsulation layer ENC may include at least one organic film to protect the display device 10 from foreign materials, such as dust.

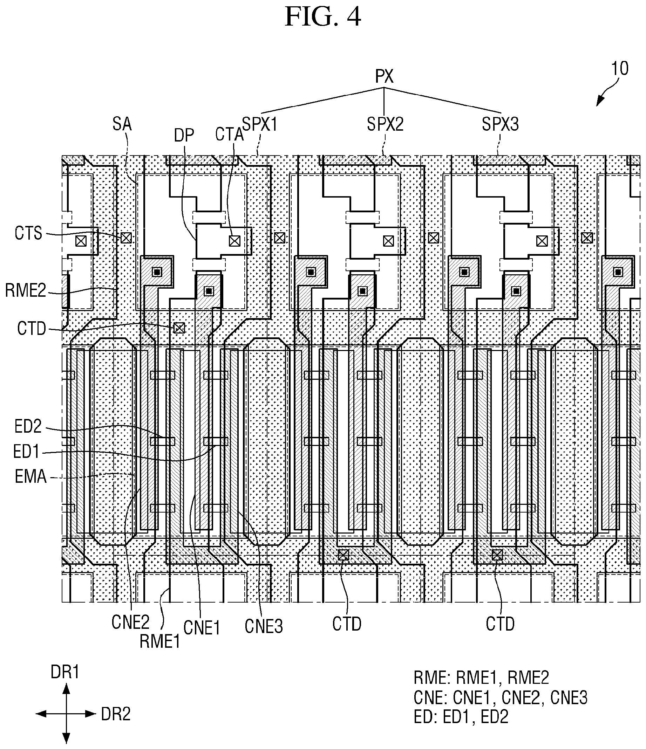

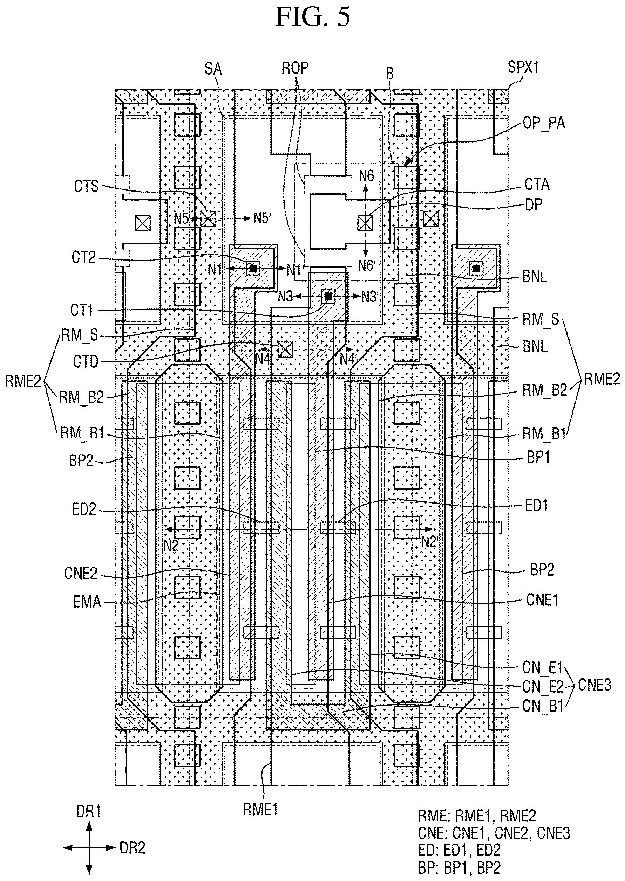

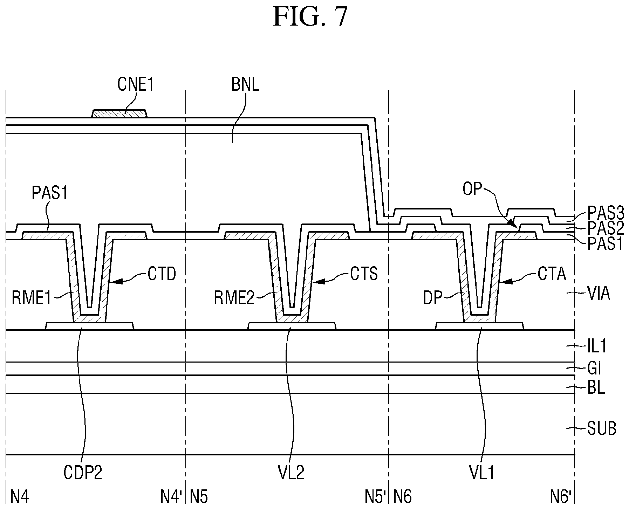

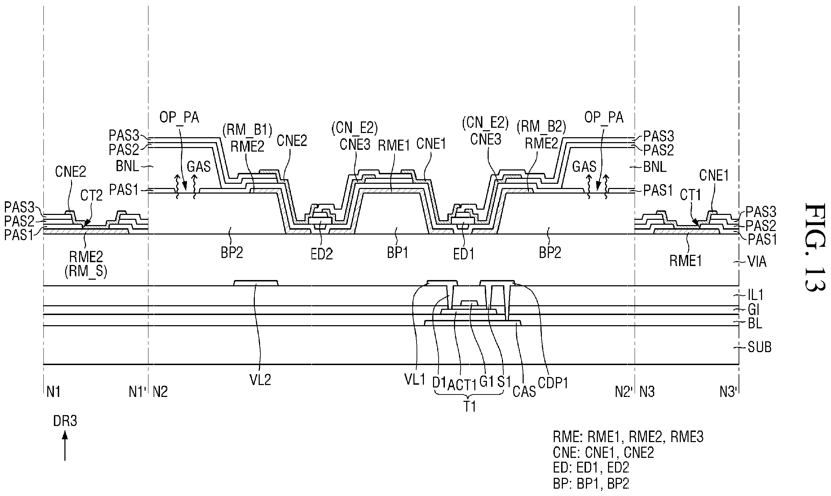

FIG. 4 is a plan view illustrating one pixel of the display device according to some embodiments. FIG. 5 is a view illustrating a first sub-pixel of FIG. 4. FIG. 6 is a cross-sectional view taken along the lines N1-N1', N2-N2', and N3-N3' of FIG. 5. FIG. 7 is a cross-sectional view taken along the lines N4-N4', N5-N5', and N6-N6' of FIG. 5. FIG. 6 illustrates a cross section crossing respective contact parts CT1 and CT2 together with both ends of light emitting elements ED1 and ED2 in the first sub-pixel SPX1. FIG. 7 illustrates a cross section crossing respective contact holes CTD, CTS, and CTA in the first sub-pixel SPX1. FIG. 13 is a schematic view illustrating outgassing through an opening hole of a first insulating layer according to some embodiments.

Referring to FIGS. 4 to 7, the display device 10 according to some embodiments may include electrodes RME (RME1 and RME2), bank patterns BP (BP1 and BP2), a bank layer BNL, and connection electrodes CNE (CNE1, CNE2, and CNE3).

The bank layer BNL may extend in the first direction DR1 and the second direction DR2 to be located in a complete lattice pattern. Areas surrounded by portions of the bank layer BNL extending in the first direction DR1 and the second direction DR2 may be an emission area EMA and a sub-area SA of each sub-pixel SPXn. Correspondingly, respective sub-pixels SPXn of one pixel PX may have substantially the same structure. Unlike some embodiments of FIG. 2, the sub-area SA may be located on the upper side of (e.g., above, in a plan view) the emission area EMA, which is one side of the emission area EMA in the first direction DR1, and emission areas EMA and sub-areas SA of different sub-pixels SPXn may be located side by side in the second direction DR2.

A plurality of bank patterns BP1 and BP2 may have a shape extending in the first direction DR1, and may be smaller than a length of the emission area EMA in the first direction DR1. In addition, widths of the plurality of bank patterns BP1 and BP2 measured in the second direction DR2 may be different from each other, and any one of the bank patterns BP1 and BP2 may be located over the sub-pixels SPXn neighboring to each other in the second direction DR2. For example, the bank patterns BP1 and BP2 may include a first bank pattern BP1 located in the emission area EMA of each sub-pixel SPXn, and a second bank pattern BP2 located over the emission areas EMA of the different adjacent sub-pixels SPXn.

The first bank pattern BP1 is located at a central portion of the emission area EMA, and the second bank patterns BP2 are spaced apart from the first bank pattern BP1 with the first bank pattern BP1 therebetween. The first bank patterns BP1 and the second bank patterns BP2 may be alternately located along the second direction DR2. The plurality of light emitting elements ED may be located between the first bank pattern BP1 and the second bank patterns BP2 spaced apart from each other.

The first bank pattern BP1 and the second bank pattern BP2 may have the same length in the first direction DR1, but may have different widths measured in the second direction DR2. A portion of the bank layer BNL extending in the first direction DR1 may overlap the second bank pattern BP2 in the thickness direction. The bank patterns BP1 and BP2 may be located as island-shaped patterns in the entirety of the display area DPA.

A plurality of electrodes RME include the first electrode RME1 located at a central portion of each sub-pixel SPXn, and the second electrodes RME2 located over the different adjacent sub-pixels SPXn. The first electrode RME1 and the second electrode RME2 may generally have a shape extending in the first direction DR1, but portions of the first electrode RME1 and the second electrode RME2 located in the emission area EMA may have different shapes.

The first electrode RME1 may be located at the center of the sub-pixel SPXn, and a portion of the first electrode RME1 located in the emission area EMA may be located on the first bank pattern BP1. The first electrode RME1 may extend from the sub-area SA in the first direction DR1, and may extend to a sub-area SA of another sub-pixel SPXn. The first electrode RME1 may have a shape in which a width thereof measured in the second direction DR2 varies depending on a position along the first direction DR1, and at least a portion of the first electrode RME1 located on the first bank pattern BP1 in the emission area EMA may have a width that is greater than that of the first bank pattern BP1. The first electrode RME1 may cover both side surfaces of the first bank pattern BP1.

The second electrode RME2 may include a portion extending in the first direction DR1, and portions branched in the vicinity of the emission area EMA. In some embodiments, the second electrode RME2 may include an electrode stem part RM_S extending in the first direction DR1, and a plurality of electrode branch parts RM_B1 and RM_B2 branched from the electrode stem part RM_S, bent in or toward the second direction DR2, and then extending again in the first direction DR1. The electrode stem part RM_S may overlap a portion of the bank layer BNL extending in the first direction DR1, and may be located on one side of the sub-area SA in the second direction DR2. The electrode branch parts RM_B1 and RM_B2 may be branched from the electrode stem part RM_S located at a portion of the bank layer BNL extending both in the first direction DR1 and in the second direction DR2, and may be bent (e.g., outwardly) to both sides corresponding the second direction DR2, respectively. The electrode branch parts RM_B1 and RM_B2 may cross the emission area EMA in the first direction DR1, may be bent again (e.g., inwardly), and may be integrated with the electrode stem part RM_S to be connected to each other. That is, the electrode branch parts RM_B1 and RM_B2 of the second electrode RME2 may be branched away from each other on the upper side of the emission area EMA of any one sub-pixel SPXn, and then connected to each other again on the lower side of the emission area EMA.

The second electrode RME2 may include a first electrode branch part RM_B1 located on the left side of a first electrode RME1, and a second electrode branch part RM_B2 located on the right side of a first electrode RME1. Hence, electrode branch parts of a second electrode RME2 may comprise a first electrode branch part on one side of a first electrode, and a second electrode branch part on an opposite side of another first electrode - the two first electrodes being in adjacent subpixels in the second direction. The electrode branch parts RM_B1 and RM_B2 included in one second electrode RME2 may be located in the emission areas EMA of sub-pixels SPXn neighboring each other in the second direction DR2, respectively, and the electrode branch parts RM_B1 and RM_B2 of a different second electrode RME2 may be located in one of the aforementioned sub-pixels SPXn and in another neighboring sub-pixel SPXn. The first electrode branch part RM_B1 of one second electrode RME2 may be located on the left side of the first electrode RME1, and the second electrode branch part RM_B2 of another second electrode RME2 may be located on the right side of the first electrode RME1.

The respective electrode branch parts RM_B1 and RM_B2 of the second electrodes RME2 may be located on respective sides of the second bank patterns BP2. The first electrode branch part RM_B1 of one second electrode RME2 may be located on the second bank pattern BP2 located on the left side of the first bank pattern BP1, and the second electrode branch part RM_B2 of another second electrode RME2 may be located on the second bank pattern BP2 located on the right side of the first bank pattern BP1. Both sides of the first electrode RME1 may be spaced apart from and face different electrode branch parts RM_B1 and RM_B2 of different second electrodes RME2, and respective intervals between the first electrode RME1 and adjacent electrode branch parts RM_B1 and RM_B2 may be less than an interval between the bank patterns BP1 and BP2.

In addition, a width of the first electrode RME1 measured in the second direction DR2 may be greater than those of the electrode stem part RM_S and the electrode branch parts RM_B1 and RM_B2 of the second electrode RME2. The first electrode RME1 may cover both sides of the first bank pattern BP1, while the second electrodes RME2 may be formed to have a relatively small width, such that the electrode branch parts RM_B1 and RM_B2 may respectively cover only one side of the second bank patterns BP2.

The first electrode RME1 may be in contact with a second conductive pattern CDP2 of a third conductive layer through a first contact hole CTD at a portion thereof overlapping a portion of the bank layer BNL extending in the second direction DR2. Unlike some embodiments corresponding to FIG. 2, the first contact hole CTD is not located in the sub-area SA, and may be located below the bank layer BNL. The second electrode RME2 may be in contact with a second voltage line VL2 of the third conductive layer through a second contact hole CTS at the electrode stem part RM_S. In addition, the first electrode RME1 may be in contact with a first connection electrode CNE1 through a first contact part CT1 of the first insulating layer PAS1 located at a portion thereof located in the sub-area SA. The second electrode RME2 may include a portion protruding from the electrode stem part RM_S in the third direction DR3 and located in the sub-area SA, and may be in contact with a second connection electrode CNE2 through a second contact part CT2 of, or defined by, the first insulating layer PAS1 and located at the protruding portion.

Meanwhile, positions of the first contact holes CTD of the sub-pixels SPXn in one pixel PX may be different from each other. For example, in the first sub-pixel SPX1, the first contact hole CTD may be located on the upper side of the emission area EMA, and in the second sub-pixel SPX2 and the third sub-pixel SPX3, the first contact holes CTD may be located on the lower side of the emission areas EMA.

The first electrodes RME1 may be located up to (e.g., to have a corresponding edge in) separation parts ROP of the sub-areas SA, while the second electrodes RME2 may not be separated in the sub-areas SA. One second electrode RME2 may include a plurality of electrode stem parts RM_S and electrode branch parts RM_B1 and RM_B2 to have a shape extending in the first direction DR1, and may be branched in the vicinity of the emission area EMA of each sub-pixel SPXn. The first electrode RME1 may be located between the separation parts ROP located in the sub-areas SA of respective adjacent sub-pixels SPXn, and may cross the emission area EMA.

According to some embodiments, the display device 10 may include a dummy pattern DP located in the sub-area SA, and located between the first electrodes RME1 of the different sub-pixels SPXn. The dummy pattern DP may be in the sub-area SA, and may be spaced apart from adjacent first electrodes RME1 with respective separation parts ROP interposed therebetween. Two separation parts ROP may be located in one sub-area SA. The dummy pattern DP may be spaced apart from the first electrode RME1 located in one sub-pixel SPXn with a lower separation part ROP interposed therebetween, and may be spaced apart from the first electrode RME1 located in another sub-pixel SPXn (e.g., another sub-pixel SPXn above and adjacent to the one sub-pixel SPXn) with an upper separation part ROP interposed therebetween.

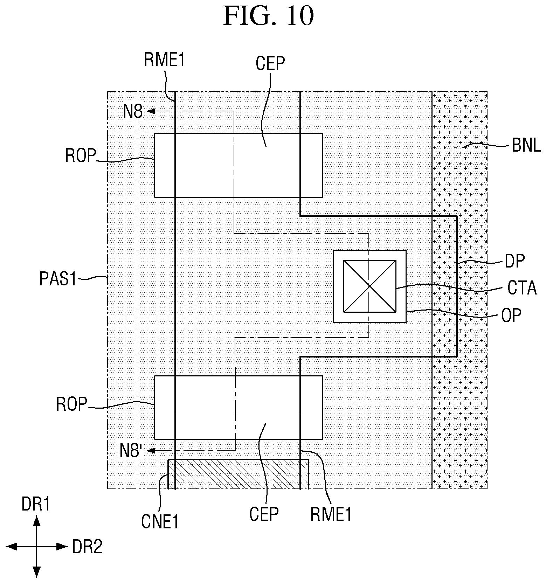

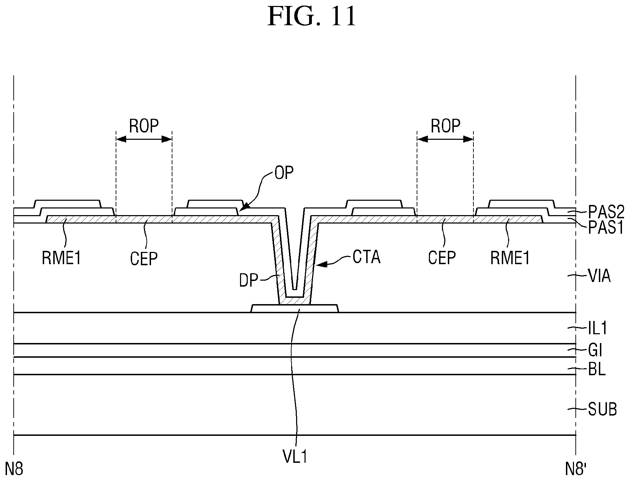

The dummy pattern DP may be initially formed in a state in which it is connected to different first electrodes RME1 through an electrode connection part CEP (e.g., see FIGS. 10 and 11). Because the first insulating layer PAS1 and the second insulating layer PAS2 are not located in the separation parts ROP, a process of removing the electrode connection part CEP may be performed in the separation parts ROP, and a plurality of first electrodes RME1 connected to the dummy pattern DP may be separated from each other.

In some embodiments, the dummy pattern DP may be connected to a first voltage line VL1 of the third conductive layer through a third contact hole CTA penetrating through the via layer VIA. The first electrode RME1 may be formed in a state in which it is connected to the dummy pattern DP, and an electrical signal applied to arrange or align the light emitting elements ED may be applied from the first voltage line VL1 to the first electrode RME1 through the dummy pattern DP. In a process of arranging or aligning the light emitting element ED, signals may be applied to the first voltage line VL1 and the second voltage line VL2, and may be transferred to the first electrode RME1 and the second electrode RME2, respectively.

The plurality of light emitting elements ED may be located on different electrodes RME between different bank patterns BP1 and BP2. The light emitting elements ED may include first light emitting elements ED1 having both ends located on the first electrode RME1 and the second electrode branch part RM_B2 of the second electrode RME2, respectively, and second light emitting elements ED2 having both ends located on the first electrode RME1 and the first electrode branch part RM_B1 of the other second electrode RME2, respectively. The first light emitting elements ED1 may be located on the right side with respect to the first electrode RME1, and the second light emitting elements ED2 may be located on the left side with respect to the first electrode RME1.

A plurality of connection electrodes CNE may include a first connection electrode CNE1 and a second connection electrode CNE2, which are first-type connection electrodes, and a third connection electrode CNE3, which is a second-type connection electrode.

The first connection electrode CNE1 may have a shape extending in the first direction DR1, and may be located on the first electrode RME1. A portion of the first connection electrode CNE1 located on the first bank pattern BP1 may overlap the first electrode RME1, and the first connection electrode CNE1 may extend from such a portion in the first direction DR1 to be located up to the sub-area SA at the upper side of the emission area EMA beyond the bank layer BNL. The first connection electrode CNE1 may be in contact with the first electrode RME1 through the first contact part CT1 in the sub-area SA.

The second connection electrode CNE2 may have a shape extending in the first direction DR1, and may be located on the second electrode RME2. A portion of the second connection electrode CNE2 located on the second bank pattern BP2 may overlap the second electrode RME2, and the second connection electrode CNE2 may extend from such a portion in the first direction DR1 to be located up to the sub-area SA at the upper side of the emission area EMA beyond the bank layer BNL. The second connection electrode CNE2 may be in contact with the second electrode RME2 through the second contact part CT2 in the sub-area SA.

The third connection electrode CNE3 may include extension parts CN_E1 and CN_E2 extending in the first direction DR1, and a first connection part CN_B1 connecting the extension parts CN_E1 and CN_E2 to each other. The first extension part CN_E1 faces the first connection electrode CNE1 in the emission area EMA and is located on the second electrode branch part RM_B2 of the second electrode RME2, and the second extension part CN_E2 faces the second connection electrode CNE2 in the emission area EMA and is located on the first electrode RME1. The first connection part CN_B1 may extend in the second direction DR2 on the bank layer BNL located on the lower side of the emission area EMA to connect the first extension part CN_E1 and the second extension part CN_E2 to each other. The third connection electrode CNE3 may be located in the emission area EMA and on the bank layer BNL, and may not be directly connected to the electrodes RME. The second electrode branch part RM_B2 located below the first extension part CN_E1 may be electrically connected to the second voltage line VL2, but a second source voltage applied to the second electrode branch part RM_B2 might not be transferred to the third connection electrode CNE3. The first connection electrode CNE1 and the second connection electrode CNE2 may be the first-type connection electrodes directly connected to the electrodes RME, and the third connection electrode CNE3 may be the second-type connection electrode that is not connected to the electrodes RME.

Meanwhile, similar to some of the above-described embodiments, the separation parts ROP, which exist after a process of separating the electrodes RME is performed, are located in the sub-area SA, and the third contact hole CTA is located in the sub-area SA as a contact hole penetrating through the via layer VIA. The first insulating layer PAS1 might not be located in the separation parts ROP, and may include an opening hole OP overlapping the third contact hole CTA, and the second insulating layer PAS2 might not be located in the separation parts ROP, but may cover the opening hole OP.

Meanwhile, the first insulating layer PAS1 of the display device according to some embodiments may include at least one opening pattern OP_PA. The at least one opening pattern OP_PA may overlap the bank layer BNL. The number of opening patterns OP_PA may be plural. The plurality of opening patterns OP_PA may be arranged along the first direction DR1, as illustrated in FIG. 5. The plurality of opening patterns OP_PA arranged along the first direction DR1 may overlap the bank layer BNL extending along the first direction DR1.

The opening pattern OP_PA may have a quadrangular shape in plan view. For example, the opening pattern OP_PA may have a square shape or a rectangular shape in plan view.

Some of the opening patterns OP_PA in plan view may be located between respective ones of the plurality of electrode branch parts RM_B1 and RM_B2, as illustrated in FIG. 5. For example, some of the opening patterns OP_PA in plan view may be located between the first electrode branch part RM_B1 and the second electrode branch part RM_B2. The opening patterns OP_PA located between the first electrode branch part RM_B1 and the second electrode branch part RM_B2 may be spaced apart from each of the first electrode branch part RM_B1 and the second electrode branch part RM_B2 adjacent thereto.

In the opening pattern OP_PA of the first insulating layer PAS1, the bank layer BNL may be in direct contact with the bank pattern BP. For example, in the opening pattern OP_PA of the first insulating layer PAS1, the bank layer BNL may be in direct contact with an upper surface of the second bank pattern BP2 overlapping the bank layer BNL in the thickness direction. In other words, as illustrated in FIG. 13, on the opening pattern OP_PA of the first insulating layer PAS1, a gas GAS trapped in the second bank pattern BP2 may be discharged upward through the bank layer BNL (e.g., see FIG. 13).

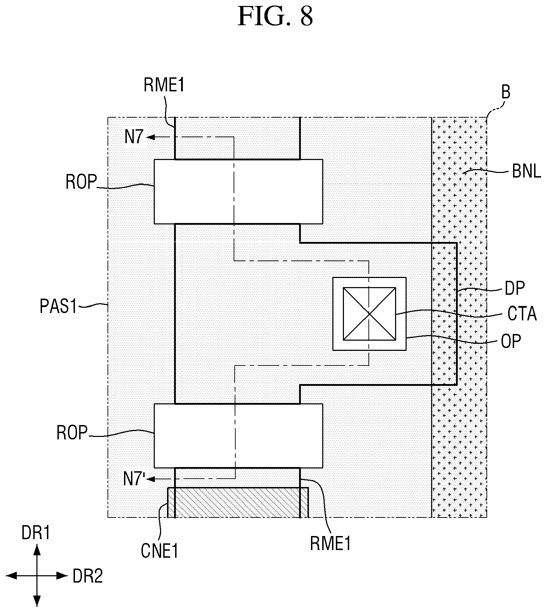

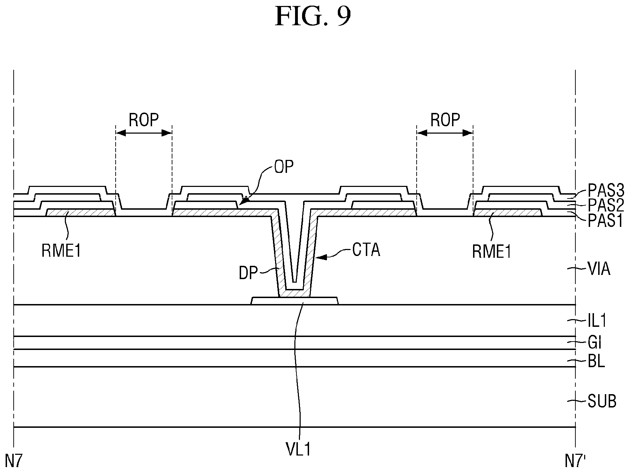

FIG. 8 is an enlarged view of portion B of FIG. 5. FIG. 9 is a cross-sectional view taken along the line N7-N7' of FIG. 8. FIG. 8 illustrates a portion in which the dummy pattern DP and the separation parts ROP are located in the sub-area SA of one sub-pixel SPXn, and FIG. 9 illustrates a cross section crossing a plurality of separation parts ROP and the opening hole OP.

Referring to FIGS. 8 and 9 in conjunction with FIG. 5, the dummy pattern DP spaced apart from the first electrodes RME1 may be located in the sub-area SA, and a plurality of insulating layers PAS1, PAS2, and PAS3 may be located on, or at respective layers above, the dummy pattern DP. In the sub-area SA of the display device 10, the plurality of separation parts ROP may be formed with the dummy pattern DP interposed therebetween, and the first electrodes RME1 of the different sub-pixels SPXn may be in contact with different separation parts ROP, respectively. The first electrode RME1 of one sub-pixel SPXn may be in contact with the separation part ROP on the lower side (e.g., in a plan view) of the dummy pattern DP, and the first electrode RME1 of another sub-pixel SPXn neighboring to the one sub-pixel SPXn in the first direction DR1 may be in contact with the separation part ROP on the upper side (e.g., in a plan view) of the dummy pattern DP. In some embodiments, the second electrode RME2 may be located so that the electrode stem part RM_S overlaps the bank layer BNL, and is spaced apart from the separation part ROP and the dummy pattern DP of the sub-area SA.

The display device 10 may be initially formed in a state in which the first electrodes RME1 and the dummy pattern DP are connected to each other in the separation parts ROP of the sub-area SA. Thereafter, a process of separating the first electrodes RME1 and the dummy pattern DP from each other is performed. A process of removing the electrode connection parts CEP connecting the dummy pattern DP and the first electrodes RME1 to each other may be performed. The first insulating layer PAS1 and the second insulating layer PAS2 might not be located in the separation parts ROP of the sub-area SA, and the third insulating layer PAS3 may cover the separation parts ROP. The third insulating layer PAS3 may be in direct contact with an upper surface of the via layer VIA in the separation parts ROP, and may be in partial direct contact with the first electrodes RME1 and the dummy patterns DP spaced apart from each other in the separation parts ROP.

The first insulating layer PAS1 might not be located on the separation parts ROP in the sub-area SA, and may include or define the opening hole OP exposing a portion of the dummy pattern DP. The opening hole OP may overlap the third contact hole CTA, and may have a diameter that is greater than that of the third contact hole CTA. In some embodiments, an area of the separation part ROP, which is a portion where the first insulating layer PAS1 is not located, may be greater than an area of the opening hole OP.

In some embodiments, the second insulating layer PAS2 may cover the entirety of the sub-area SA except for the separation parts ROP. The second insulating layer PAS2 may be in direct contact with the dummy pattern DP while covering the opening hole OP. The process of removing the electrode connection parts CEP in the sub-area SA may be performed in a state in which the first insulating layer PAS1 and the second insulating layer PAS2 are not located in the separation parts ROP, and an area other than the separation parts ROP may be protected by the second insulating layer PAS2.

FIGS. 10 and 11 are views illustrating shapes of electrodes in a sub-area in a process of manufacturing the display device. FIG. 10 is a plan view illustrating a state in which the dummy pattern DP and the first electrodes RME1 are connected to each other by the electrode connection parts CEP in the sub-area SA, and FIG. 11 is a cross-sectional view taken along the line N8-N8' of FIG. 10, and illustrates a cross section crossing the separation parts ROP and the opening hole OP.

Referring to FIGS. 10 and 11, the display device 10 may be formed in a state in which the first electrodes RME1 and the dummy pattern DP located in each sub-pixel SPXn are connected to each other by the electrode connection parts CEP. The dummy pattern DP may be connected to the first electrodes RME1 located on the upper side and the lower side of the dummy pattern DP (e.g., in a plan view) by the electrode connection parts CEP, respectively. Because the electrode connection parts CEP are removed in a subsequent process, the separation parts ROP of the sub-area SA may be set as areas in which the electrode connection parts CEP are located.

The first insulating layer PAS1 may cover the electrodes RME, but may also expose a portion of the electrode connection parts CEP and the dummy pattern DP. Locations of portions of the electrode connection parts CEP respectively connecting the dummy pattern DP and the first electrodes RME to each other become the separation parts ROP, and the first insulating layer PAS1 is not located on the separation parts ROP. In addition, the first insulating layer PAS1 may include or define an opening hole OP exposing a portion of the dummy pattern DP overlapping the third contact hole CTA.

The light emitting elements ED are arranged in the emission area EMA by applying electrical signals to the electrodes RME in a state in which the first insulating layer PAS1 is formed. The electrical signals may be applied to the first voltage line VL1 and the second voltage line VL2, and the electrical signal applied to the first voltage line VL1 may be transferred to the dummy pattern DP connected to the first voltage line VL1 through the third contact hole CTA. Because the dummy pattern DP is connected to the first electrodes RME1 through the electrode connection parts CEP, the electrical signal may be transferred to the first electrodes RME1.

The second insulating layer PAS2 may cover the light emitting elements ED after the light emitting elements ED are located. The second insulating layer PAS2 may cover the emission area EMA and the sub-area SA, but might not be located in the separation parts ROP. Because the process of removing the electrode connection parts CEP is performed at the separation parts ROP, the second insulating layer PAS2 may expose the electrode connection parts CEP. On the other hand, the second insulating layer PAS2 covers the opening hole OP of the first insulating layer PAS1 in the sub-area SA, and thus, the dummy pattern DP may not be completely exposed (e.g., may be partially covered).

Thereafter, in the process of removing the electrode connection parts CEP, areas of the sub-areas SA other than the separation parts ROP are covered by the second insulating layer PAS2, and thus, damage to the other electrodes RME due to residues generated in a patterning process may be reduced or prevented. For example, the second insulating layer PAS2 covers the opening hole OP, such that the dummy pattern DP overlapping the third contact hole CTA may be protected.

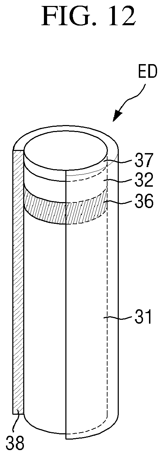

FIG. 12 is a view illustrating a light emitting element according to some embodiments.

Referring to FIG. 12, the light emitting element ED may be a light emitting diode. For example, the light emitting element ED may have a size of a micro-meter or a nano-meter scale, and may be an inorganic light emitting diode including an inorganic material. The inorganic light emitting diode may be aligned between two electrodes facing each other according to an electric field formed in a corresponding direction between the two electrodes.

The light emitting element ED may have a shape extending in one direction. The light emitting element ED may have a shape such as a rod shape, a wire shape, or a tube shape. As an example, the light emitting element ED may have a cylindrical shape or a rod shape. As another example, the light emitting element ED may have various shapes, for example, a polygonal prismatic shape such as a cubic shape, a rectangular parallelepiped shape, or a hexagonal prismatic shape or a shape extending in one direction and partially inclined. A plurality of semiconductors of the light emitting element ED may have a structure in which they are sequentially located or stacked along one direction.

The light emitting element ED may include a first semiconductor layer 31, a second semiconductor layer 32, an active layer 36, an electrode layer 37, and an insulating film 38.

The first semiconductor layer 31 may be an n-type semiconductor. For example, when the light emitting element ED emits blue light, the first semiconductor layer 31 may include a semiconductor material having a chemical formula of AlxGayIn1 -x-yN (0 ≤ x ≤ 1, 0 ≤ y ≤ 1, and 0 ≤ x + y ≤ 1). The first semiconductor layer 31 may include at least one semiconductor material of AlGaInN, GaN, AIGaN, InGaN, AIN, and InN doped with an n-type dopant. The first semiconductor layer 31 may be doped with an n-type dopant such as Si, Ge, or Sn. The first semiconductor layer 31 may be made of n-GaN doped with n-type Si. A length of the first semiconductor layer 31 may be in the range of about 1.5 µm to about 5 µm, but embodiments of are not limited thereto.

The second semiconductor layer 32 may be located on the active layer 36. For example, when the light emitting element ED emits blue light or green light, the second semiconductor layer 32 may include a semiconductor material having a chemical formula of AlxGayIn1 -x-yN (0 ≤ x ≤ 1, 0 ≤ y ≤ 1, and 0 ≤ x + y ≤ 1). For example, the second semiconductor layer 32 may include at least one semiconductor material of AlGaInN, GaN, AIGaN, InGaN, AIN, and InN doped with a p-type dopant. The second semiconductor layer 32 may be doped with a p-type dopant such as Mg, Zn, Ca, Se, or Ba. The second semiconductor layer 32 may be made of p-GaN doped with p-type Mg. A length of the second semiconductor layer 32 may be in the range of about 0.05 µm to about 0.10 µm, but embodiments are not limited thereto.

Each of the first and second semiconductor layers 31 and 32 may be formed as one layer, but embodiments are not limited thereto. For example, each of the first and second semiconductor layers 31 and 32 may have a plurality of layers by further including a clad layer or a tensile strain barrier reducing (TSBR) layer.

The active layer 36 may be located between the first and second semiconductor layers 31 and 32. The active layer 36 may include a material having a single or multiple quantum well structure. When the active layer 36 includes the material having the multiple quantum well structure, the active layer 36 may include a plurality of quantum layers and well layers that are alternately stacked. The active layer 36 may emit light by a combination of electron-hole pairs according to an electrical signal applied through the first and second semiconductor layers 31 and 32. For example when the active layer 36 emits blue light, the active layer 36 may include a material such as AIGaN or AlGaInN. When the active layer 36 has a multiple quantum well structure, that is, a structure in which the quantum layers and the well layers are alternately stacked, the quantum layers may include a material such as AIGaN or AlGaInN, and the well layers may include a material such as GaN or AllnN. The active layer 36 may emit the blue light by including AlGaInN as a material of the quantum layers and AllnN as a material of the well layers.

As another example, the active layer 36 may have a structure in which semiconductor materials having large band gap energy and semiconductor materials having small band gap energy are alternately stacked, and may include Group III to Group V semiconductor materials depending on a wavelength band of emitted light. The light emitted by the active layer 36 is not limited to the blue light, and in some case, the active layer 36 may emit red or green light. A length of the active layer 36 may be in the range of about 0.05 µm to about 0.10 µm, but embodiments are not limited thereto.

The light emitted from the active layer 36 may be emitted not only in a length direction of the light emitting element ED, but also to both sides of the light emitting element ED. Directions of the light emitted from the active layer 36 are not particularly limited in embodiments.

The electrode layer 37 may be an ohmic contact electrode. As another example, the electrode layer 37 may be a Schottky contact electrode. The light emitting element ED may include at least one electrode layer 37. The electrode layer 37 may decrease resistance between the light emitting element ED and either an electrode or a connection electrode CTE when the light emitting element ED is electrically connected thereto. The electrode layer 37 may include a metal having conductivity. The electrode layer 37 may include at least one of aluminum (Al), titanium (Ti), indium (In), gold (Au), silver (Ag), indium tin oxide (ITO), indium zinc oxide (IZO), and indium tin zinc oxide (ITZO). The electrode layer 37 may also include an n-type or p-type doped semiconductor material.

The insulating film 38 may surround outer surfaces of the plurality of semiconductor layers and the electrode layers. The insulating film 38 may surround an outer surface of the active layer 36, and may extend in a direction in which the light emitting element ED extends. The insulating film 38 may protect the light emitting element ED. For example, the insulating film 38 may surround a side surface of the light emitting element ED, and may expose both ends of the light emitting element ED in the length direction.

The insulating film 38 may include materials having insulating properties, such as silicon oxide (SiOₓ), silicon nitride (SiNₓ), silicon oxynitride (SiOₓN_{y}), aluminum nitride (AIN), and aluminum oxide (Al₂O₃). Accordingly, the insulating film 38 may reduce or prevent the likelihood of an electrical short circuit that may occur when the active layer 36 is in direct contact with an electrode through which an electrical signal is transferred to the light emitting element ED. In addition, the insulating film 38 protects an outer surface of the light emitting element ED as well as the active layer 36, and thus may reduce or prevent a decrease in luminous efficiency.

An outer surface of the insulating film 38 may be surface-treated. When the display device 10 is manufactured, an ink (e.g., a predetermined ink) may be jetted onto electrodes in a state in which the light emitting elements ED are dispersed in the ink, such that the light emitting elements 300 may be aligned. Here, a hydrophobic or hydrophilic treatment is performed on a surface of the insulating film 38, such that the light emitting elements ED may be maintained in a state in which the light emitting elements ED are dispersed without being agglomerated with other adjacent light emitting elements ED in the ink.

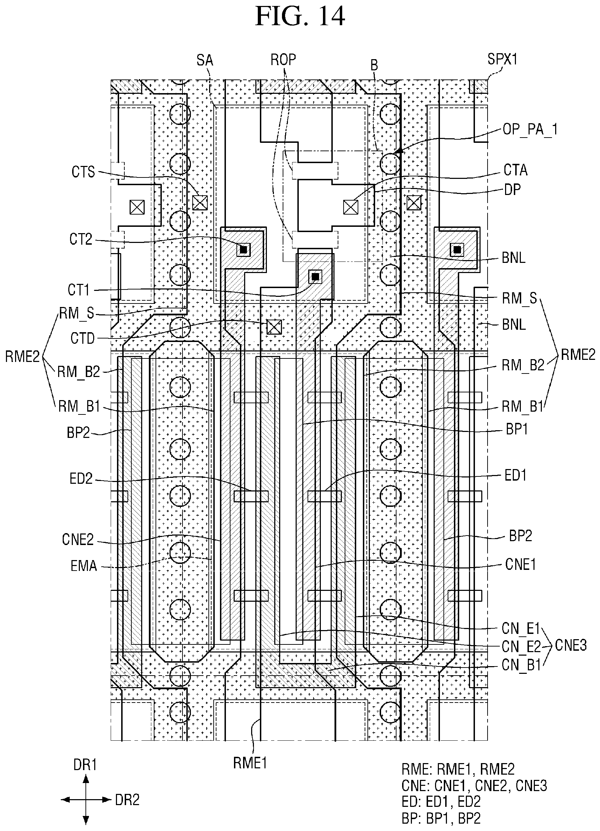

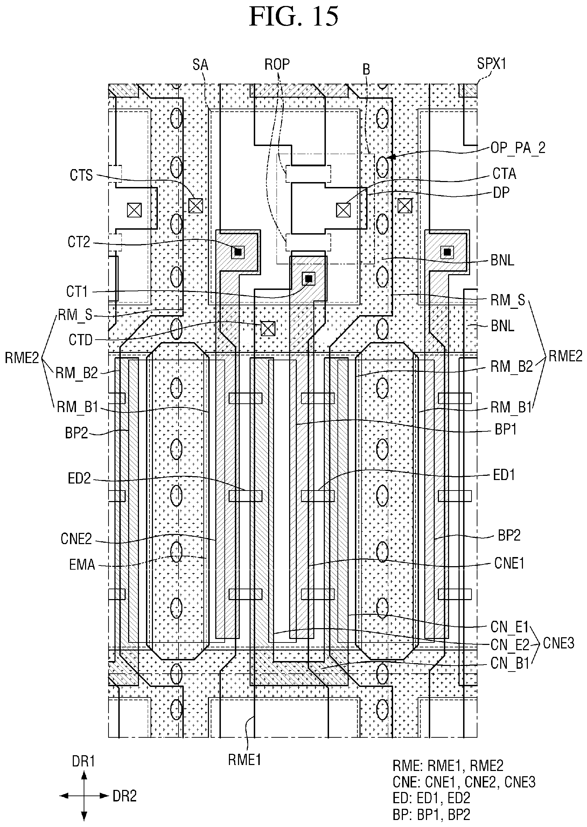

FIG. 14 is a plan view illustrating one pixel of a display device according to other embodiments. FIG. 15 is a plan view illustrating one pixel of a display device according to still other embodiments.

Referring to FIGS. 14 and 15, display devices according to the present embodiments are different from the display device according to embodiments corresponding to FIG. 5 in that shapes of opening patterns OP_PA_1 and OP_PA_2 in plan view are different from that of the opening pattern OP_PA.

For example, as illustrated in FIG. 14, a shape of the opening pattern OP_PA_1 in plan view may be circular. In addition, as illustrated in FIG. 15, a shape of the opening pattern OP_PA_1 in plan view may be elliptical.

However, embodiments of the present disclosure are not limited thereto, and the shapes of the opening patterns OP_PA_1 and OP_PA_2 in plan view may be modified. For example, the shapes of the opening patterns OP_PA_1 and OP_PA_2 in plan view may also be triangular, pentagonal, or hexagonal.

As discussed above, embodiments can provide a display device comprising: sub-pixels comprising a light emitting part, and a sub-area on a side of the light emitting part in a first direction; a first electrode in the light emitting part and extending in the first direction, and a second electrode extending in the first direction and spaced apart from the first electrode in a second direction crossing the first direction; a first insulating layer on the first electrode and the second electrode; and a light emitting element on the first electrode and the second electrode in the light emitting part, wherein the second electrode comprises an electrode stem part extending in the first direction, and electrode branch parts branched from the electrode stem part.

The sub-pixels may be arranged in rows and columns. For example, with rows arranged in one of the first and second directions, and columns arranged in the other of the first and second directions.

The electrode branch parts may correspond to the light emitting part of each subpixel.

The electrode branch parts of each second electrode may comprise a first electrode branch and a second electrode branch part. The first electrode branch part and the second electrode branch part may branch from the electrode stem part in opposite directions along an axis defined in the second direction. The first electrode branch part and the second electrode branch part may be spaced apart from each other and extend in the first direction, before branching back towards each other to connect to the electrode stem part. The electrode stem part may connect sets of adjacent first and second electrode branch parts in the first direction.

The electrode branch parts of a second electrode may comprise a first electrode branch part on one side of a first electrode, and a second electrode branch part on an opposite side of another first electrode - these two first electrodes being in adjacent subpixels in the second direction.

The electrode branch parts of one second electrode may be respectively in the light emitting parts of adjacent ones of the sub-pixels neighboring in the second direction.

Each subpixel may comprise a plurality of light emitting elements in the light emitting part. For example, the light emitting part may comprise two light emitting elements spaced part in the second direction. The light emitting elements may comprise an LED with opposite ends aligned in the second direction.

The first electrode of the subpixel may be connected to respective ends of two adjacent light emitting elements spaced part in the second direction. On one side in the second direction, the other ends of the light emitting elements are connected to one of the second electrode branch parts of that subpixel, and on the other side in the second direction, the other ends of the light emitting elements are connected to the other the second electrode branch parts of that subpixel. The subpixel may comprise multiple sets of two light emitting elements spaced part in the second direction.

As discussed above, embodiments can provide a display device comprising: sub-pixels comprising a light emitting part, and sub-areas on respective sides of the light emitting part in a first direction; a first electrode in the light emitting part and extending in the first direction, and a second electrode extending in the first direction and spaced apart from the first electrode in a second direction crossing the first direction; a first insulating layer on the first electrode and the second electrode; a light emitting element on the first electrode and the second electrode in the light emitting part; a first bank pattern at a central portion of the light emitting part below the first electrode and the second electrode; second bank patterns spaced apart from the first bank pattern with the first bank pattern interposed therebetween; and a bank layer on the first insulating layer, and separating adjacent ones of the sub-pixels, wherein the light emitting element is between the first bank pattern and one of the second bank patterns, and wherein the first insulating layer defines an opening pattern overlapping the bank layer.

Embodiments of the present disclosure have been described hereinabove with reference to the accompanying drawings, but it will be understood by one of ordinary skill in the art to which the present disclosure pertains that various modifications and alterations may be made without departing from essential feature of the present disclosure. Therefore, it is to be understood that the embodiments described above are illustrative rather than being restrictive in all aspects.

## Claims

1. A display device comprising:
sub-pixels comprising a light emitting part, and a sub-area on a side of the light emitting part in a first direction;
a first electrode in the light emitting part and extending in the first direction, and a second electrode extending in the first direction and spaced apart from the first electrode in a second direction crossing the first direction;
a first insulating layer on the first electrode and the second electrode; and
a light emitting element on the first electrode and the second electrode in the light emitting part,
wherein the second electrode comprises an electrode stem part extending in the first direction, and electrode branch parts branched from the electrode stem part.

2. The display device of claim 1, further comprising a bank layer separating adjacent ones of the sub-pixels,
wherein the sub-pixels are arranged along the first direction and the second direction.

3. The display device of claim 2, wherein the bank layer is in a lattice shape along the first direction and the second direction.

4. The display device of claim 3, wherein the light emitting part and the sub-area are surrounded by portions of the bank layer extending in the first direction and the second direction.

5. The display device of claim 4, wherein the first electrode is over the sub-area, and defines an opening hole in the sub-area.

6. The display device of claim 5, further comprising:
a second insulating layer on the first insulating layer; and
separation parts respectively in sub-areas, the first insulating layer and the second insulating layer not being therein,
wherein the first electrode contacts adjacent ones of the separation parts of adjacent ones of the sub-areas.

7. The display device of claim 6, further comprising:
a first connection electrode on the first electrode in the light emitting part, and in contact with the light emitting element; and
a second connection electrode on the second electrode in the light emitting part, and in contact with the light emitting element,
wherein the first insulating layer further comprises a first contact part overlapping the first electrode in the light emitting part, and a second contact part overlapping the second electrode in the light emitting part,
wherein the first connection electrode is in contact with the first electrode through the first contact part, and
wherein the second connection electrode is in contact with the second electrode through the second contact part.

8. The display device of claim 6 or 7, further comprising a third insulating layer on the second insulating layer, and covering the separation parts in the sub-area.

9. The display device of any one of claims 2 to 8, wherein the electrode stem part overlaps a portion of the bank layer extending in the first direction, and is on one side of the sub-area in the second direction.

10. The display device of claim 9, wherein the electrode branch parts are branched from a first portion of the electrode stem part at a portion of the bank layer extending in the first direction and at a portion of the bank layer extending in the second direction, and are bent to respective sides in the second direction.

11. The display device of claim 10, wherein the electrode branch parts cross the light emitting part in the first direction, are bent again, and are integrated with a second portion of the electrode stem part to be connected to each other;
optionally wherein the electrode branch parts of the second electrode comprise a first electrode branch part on one side of a first electrode, and a second electrode branch part on an opposite side of another first electrode;
optionally wherein the electrode branch parts in one second electrode are respectively in the light emitting parts of adjacent ones of the sub-pixels neighboring in the second direction, and wherein the electrode branch parts of different ones of the second electrodes are in one sub-pixel.

12. The display device of any one of claims 1 to 11, further comprising a first bank pattern at a central portion of the light emitting part, and second bank patterns spaced apart from the first bank pattern with the first bank pattern interposed therebetween,
wherein the first bank pattern and the second bank patterns are alternately arranged along the second direction, and
wherein the light emitting element is between the first bank pattern and one of the second bank patterns;
optionally wherein the first electrode is at a center region of the sub-pixel, wherein a portion of the first electrode in the light emitting part is on the first bank pattern, and wherein the first electrode extends in the first direction from the sub-area to a sub-area of an adjacent sub-pixel;
further optionally wherein a width of the first electrode in the second direction is different depending on a position thereof in the first direction, and wherein the portion of the first electrode in the light emitting part on the first bank pattern has a width that is greater than a width of the first bank pattern;
still further optionally wherein the first electrode covers both side surfaces of the first bank pattern.

13. A display device comprising:
sub-pixels comprising a light emitting part, and a sub-areas on a side of the light emitting part in a first direction;
a first electrode in the light emitting part and extending in the first direction, and a second electrode extending in the first direction and spaced apart from the first electrode in a second direction crossing the first direction;
a first insulating layer on the first electrode and the second electrode;
a light emitting element on the first electrode and the second electrode in the light emitting part;
a first bank pattern at a central portion of the light emitting part below the first electrode and the second electrode;
second bank patterns spaced apart from the first bank pattern with the first bank pattern interposed therebetween; and
a bank layer on the first insulating layer, and separating adjacent ones of the sub-pixels,
wherein the light emitting element is between the first bank pattern and one of the second bank patterns, and
wherein the first insulating layer defines an opening pattern overlapping the bank layer.

14. The display device of claim 13, wherein the sub-pixels are arranged along the first direction and the second direction,
wherein the bank layer is in a lattice shape along the first direction and the second direction, and
wherein the opening pattern is arranged along the bank layer, and extends in the first direction in plan view.

15. The display device of claim 14, wherein the second electrode comprises an electrode stem part extending in the first direction, and electrode branch parts branched from the electrode stem part, and
wherein the opening pattern is between the electrode branch parts in plan view.
